(19)

Europäisches
Patentamt
European
Patent Office
Office européen
des brevets

(11) **EP 2 015 086 A1**

(12) **EUROPEAN PATENT APPLICATION**

(43) Date of publication:
**14.01.2009 Bulletin 2009/03**

(51) Int Cl.:
***G01R 31/26*** *(2006.01)*      *H03K 17/687* *(2006.01)*

(21) Application number: **07013817.7**

(22) Date of filing: **13.07.2007**

| | |
|---|---|
| (84) Designated Contracting States:<br>**AT BE BG CH CY CZ DE DK EE ES FI FR GB GR HU IE IS IT LI LT LU LV MC MT NL PL PT RO SE SI SK TR**<br>Designated Extension States:<br>**AL BA HR MK RS** | (72) Inventors:<br> • **Bernacchia, Giuseppe, Dr.**<br>  **35027 Noventia Padovana**<br>  **Padova (IT)**<br> • **Capodivacca, Giovanni**<br>  **35134 Padova (IT)** |
| (71) Applicant: **Infineon Technologies Austria AG**<br>**9500 Villach (AT)** | (74) Representative: **Bickel, Michael**<br>**Westphal, Mussgnug & Partner**<br>**Patentanwälte**<br>**Herzog-Wilhelm-Strasse 26**<br>**80331 München (DE)** |

(54)    **Method for measuring an on-resistance of a load-path of a transistor**

(57)    A method for measuring an on-resistance of a load-path of a transistor is disclosed. The transistor comprises a control terminal and its load path is connected between the first and the second supply terminal. The method comprises the following steps: applying a control signal to the control terminal of the transistor for switching the transistor into an on-state, such that the transistor carries a load current, measuring a voltage drop across the load-path of the transistor yielding a first measurement value, feeding a test current into the load-path of the transistor, such that the test current and the load current superpose, measuring a voltage drop across the load-path of the transistor yielding a second measurement value, and determining the on-resistance of the load-path of the transistor from difference of the first and second measurement value.

EP 2 015 086 A1

**Description**

The invention relates to a method for measuring the on-resistance of a load-path of a transistor which allows in-circuit measurements especially at power MOSFETs or similar power switching devices.

Particularly DC-DC switching regulators often employ a control loop with current feedback. An easy, inexpensive and therefore attractive method for sensing load currents of a transistor is to measure the voltage drop over a load-path of the respective transistor. Such a method is very effective because it does not require any external components and it is lossless since it makes use of a parameter inherent to the transistor, i.e. the on-resistance, whereas other methods such as measuring the voltage drop over a shunt-resistor entails a loss of power proportional to the resistance of the shunt-resistor.

In order to be able to determine the load current of a transistor by measuring the voltage drop over the load-path of the transistor, it is necessary that the on-resistance of the load-path of the transistor is known. In present applications the resistance value given by suppliers of the transistors is used for calculating the load current from the measured voltage drop over the load-path of the transistor. The resistance values of the on-resistance given by suppliers or manufacturers often exhibit tolerance ranges of 40 percent of its nominal value, what entails intolerable inaccuracies of the current measurement. Additionally the resistance value of the on-resistance of a transistor can considerable vary over temperature.

It is an object of the present invention to provide a method for an in-circuit measurement of the on-resistance of a load-path of a transistor in order to be able to precisely measure the on-resistance of a transistor during operation for performing a calibration or recalibration of a current measurement of the load current through the transistor.

This object is achieved by a method according to claim 1. Exemplary embodiments are subject matter of the dependent claims.

Accordingly, one example of the invention relates to a method for measuring an on-resistance of a load-path of a transistor which has a control terminal and is connected between the first and the second supply terminal. The method comprises the following steps: applying a control signal to the control terminal of the transistor for switching the transistor into an on-state, such that the transistor carries a load current, measuring a voltage drop across the load-path of the transistor yielding a first measurement value, feeding a test current into the load-path of the transistor, such that the test current and the load current superpose, measuring a voltage drop across the load-path of the transistor yielding a second measurement value, and determining the on-resistance of the load-path of the transistor from difference of the first and second measurement value.

In one example of the invention the step of measuring a voltage drop across the load-path of the transistor comprises the steps of amplifying by a first factor the voltage drop across the load-path of the transistor yielding the first measurement value, and digitizing the first measurement value yielding a first digital value.

In one example of the invention the test current is provided by a current source. The test current may also be determined by a resistance being connected between the load-path of the transistor and one of the supply terminals, wherein the resistance may be a series circuit of a shunt-resistor and a further resistor for limiting the current. The value of the test current can be determined by measuring the voltage drop across the shunt-resistor.

According to a further example of the invention a circuit arrangement for measuring an on-resistance of a load-path of a first transistor is provided. The first transistor is connected between a first and a second supply terminal and carries a load current. The circuit arrangement comprises a measurement device connected with the first transistor for measuring the voltage drop across the load-path of the first transistor and for providing a measurement signal being a representation of the voltage drop, a switchable current source for providing a test current to the load-path of the first transistor, such that the test current and the load current can superpose, the current source being capable of being switched on and off by a switch which is responsive to a control signal, an evaluation circuit adapted for providing a control signal for the switch, for storing the measurement signal, and for calculating the on-resistance of the load-path of the first transistor from the test current, an actual measurement signal, and a stored measurement signal, where at least one of the measurement signals has been measured with the current source switched on.

In the following the invention will be explained in more detail by reference to the following figures:

Figure 1      shows a circuit for determining the load current of a transistor by measuring the voltage drop across the load-path of the transistor having a known on-resistance.

Figure 2a     shows a circuit diagram of a circuit arrangement for an in-circuit measurement of the on-resistance of a transistor in order to be able to perform a current measurement by measuring the voltage drop across a load-path of the transistor having an apriori unknown on-resistance.

Figure 2b     shows the circuit of figure 2a being adapted for precalibrating the shunt-resistor which is employed for measuring the test current.

In the figures equal reference symbols denote equal components or equal signals with the same meaning.

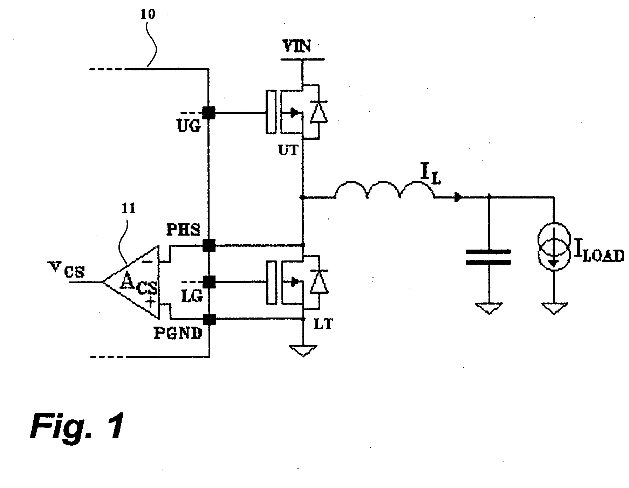

Figure 1 depicts a circuit diagram of a half bridge comprising a high-side transistor UT connected between first supply terminal VIN and an output terminal, and a low-side transistor LT connected between the output terminal and a second supply terminal GND. A load circuit represented by an inductor, a capacitor and a current source is connected to the output terminal of the half bridge, the output terminal providing a load current $I_L$ to the load circuit. Each transistor of the half bridge comprises a control terminal connected to a control circuit 10 integrated in a semiconductor chip. The semiconductor chip comprises a first and a second terminal UG and LG being connected with the control terminals of the high-side transistor UT and the low-side transistor LT. The first and the second terminal UG and LG are connected to driver circuits for high-side and the low-side transistor of the half bridge (not shown), the driver circuits being also part of the control circuit 10 in the semiconductor chip.

The control circuit 10 further comprises a first amplifier 11 connected to the load terminals of the low-side transistor LT of the half bridge for amplifying the voltage drop across the load-path of the low-side transistor LT. This voltage drop across the low path is amplified by a factor $A_{CS}$. The output signal of the first amplifier 11 is a first measurement signal $v_{cs}$. Assuming the high-side transistor UT is in an off-state and the low-side transistor LT is in an on-state, the output current $I_L$ has to flow through the load-path of the low-side transistor LT resulting in an voltage drop of $R_{ON} \cdot I_L$ across the load-path, wherein $R_{ON}$ denotes the on-resistance of the low-side transistor LT. Accordingly, the output of the first amplifier 11, that is the first measurement signal $v_{CS}$, equals:

$$v_{cs} = A_{cs} \cdot R_{ON} \cdot I_L \tag{1}$$

The first measurement signal $v_{cs}$ is, according to equation (1), proportional to the current $I_L$ through the load-path of the low-side transistor LT. For actually calculating the current $I_L$ through the load-path of the transistor the on-resistance $R_{ON}$ of the transistor has to be known. Figure 1 shows a load current measurement of the low-side transistor of a half bridge. Of course the load current of the high-side transistor UT of the half bridge can be measured in an analogue manner.

As mentioned above, the resistance values for the on-resistance $R_{ON}$ can vary due to tolerances in the production process, so that, as a consequence, the resistance values given by the manufactures or the suppliers of power transistors exhibit a tolerance range of up to 40 percent of the nominal value, what entails a very inaccurate current measurement results. Moreover the on-resistance $R_{ON}$ of a transistor changes over temperature, wherein the temperature behaviour is non-linear. However, there is a need for a calibration method for calibrating the current measurement circuit in order to achieve a more accurate measurement of the load current $I_L$.

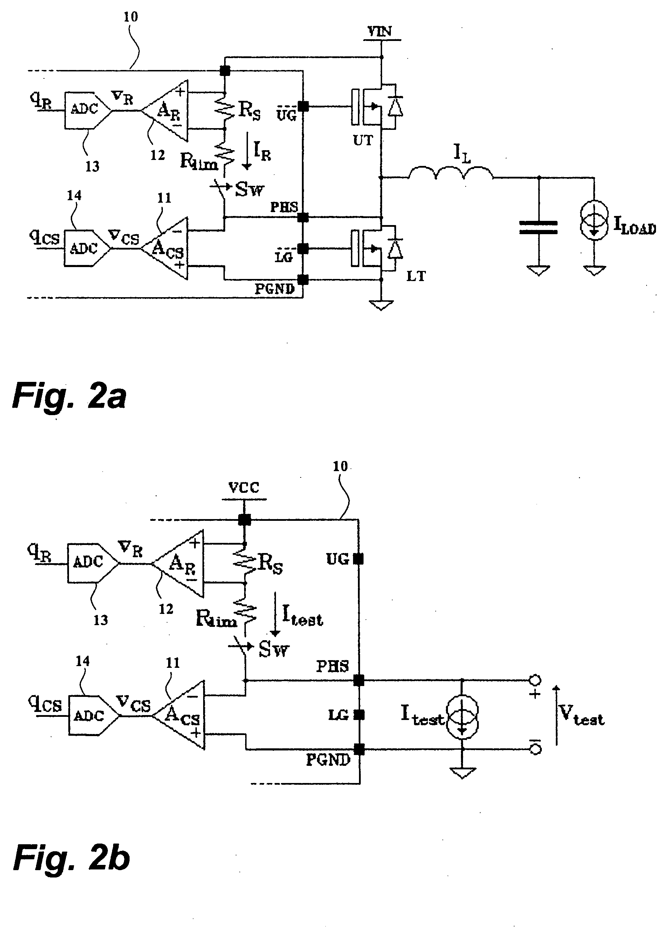

Figure 2a shows a circuit diagram of a control circuit 10 comprising a circuit arrangement for measuring the load current through a load-path of a transistor similar to the circuit arrangement of figure 1. The control circuit 10 of figure 2a additionally comprises circuit components for measuring the a-priori unknown on-resistance $R_{ON}$ of the load-path of the transistor whose load current is to be measured. The measured on-resistance $R_{ON}$ may be used to determine the actual value of the load current through the transistor, i.e. the on-resistance $R_{ON}$ is measured for calibrating the load current measurement.

In the example of figure 2a the transistor whose load current is to be measured is a low-side transistor LT of a half bridge. Similar to figure 1, figure 2a shows a control circuit 10 for driving and controlling the half bridge connected to the control circuit 10. The control circuit 10 comprises a current measurement circuit with an amplifier 11 and an analog-to-digital converter 14. The inputs of the amplifier 11 are connected via terminals PHS and PGND to the first and the second load terminal of the low-side transistor LT respectively, such that the voltage drop across the load-path of the transistor LT is amplified by the amplifier 11 by a gain factor $A_{CS}$ yielding a first measurement signal $v_{cs}$ which is the output signal of the amplifier 11. The first measurement signal $v_{cs}$ is supplied to the analog-to-digital converter 14 converted into a first sequence of a digital values $q_{cs}(k)$. The first load terminal of the transistor LT is connected to the first supply terminal VIN via a series circuit of a switch Sw, a shunt-resistor $R_S$, and a further resistor $R_{lim}$. The further resistor $R_{lim}$ is not necessarily a separate resistive component but may also be formed by the on-resistance of the switch Sw. If the supply voltage varies over a wide range it may be useful to use an (e.g. electronically) adjustable resistor as further resistor $R_{lim}$, so that the resistance of the resistor can be increased when the supply voltage increases.

If the low-side transistor LT is in an on-state a test current $I_R$ is injected into the load-path of the transistor LT, if the switch Sw is closed. The test current $I_R$ flowing from the first supply terminal VIN through the load-path of the transistor LT to the second supply terminal GND is determined by observing the voltage drop over the shunt-resistor $R_S$. Therefore a second amplifier 12 has its inputs connected to a first and a second terminal of the shunt-resistor $R_S$ respectively and provides as its output signal a second measurement signal $v_R$ which is proportional to the test current $I_R$ and calculates as follows:

$$v_R = A_R \cdot R_s \cdot I_R \, , \tag{2}$$

wherein the amplifier 12 has a second gain factor $A_R$. The second measurement signal $V_R$ is supplied to a second analog-to-digital converter 13 for converting the second measurement signal $V_R$ into a second sequence of digital values $q_R(k)$.

The method for measuring the on-resistance of the load-path of the transistor LT performed by means of the control circuit 10 of figure 2a comprises the following steps:

(A) Applying a control signal to the control terminal LG of the transistor LT for switching the transistor LT into an on-state, such that the transistor LT carries a load current $I_L$. In this state of operation the high-side switch UT of the half bridge is usually (but not necessarily) in an off-state.

(B) Measuring the voltage drop across the load-path of the transistor LT yielding a first measurement value $v_{cs}(k)$ of the first measurement signal $v_{cs}$.

(C) Feeding a test current $I_R$ into the load-path of the transistor LT, such that the test current $I_R$ and the load current $I_L$ superpose. Since the transistor LT provides a low-resistance current path for the test current $I_R$, the test current $I_R$ does not flow into the load circuit, but it sunken by the low-side transistor LT.

(D) Measuring a voltage across the load-path of the transistor LT yielding a second measurement value $v_{CS}(k+1)$ of the first measurement signal $v_{CS}$.

(E) Determining the on-resistance $R_{ON}$ of the load-path of the transistor LT from the difference of the first and the second measurement value $v_{CS}(k)-v_{CS}(k+1)$.

It can be easily derived that the first measurement value $v_{CS}(k)$ and the second measurement value $v_{CS}(k+1)$ can be calculated as follows:

$$v_{CS}(k) = A_{CS} \cdot R_{ON} \cdot I_L \, , \tag{3}$$

$$v_{CS}(k+1) = A_{CS} \cdot R_{ON} \cdot (I_L - I_R) . \tag{4}$$

Taking the difference of the first measurement value $V_{CS}(k)$ and the second measurement value $V_{CS}(k+1)$, that is the difference between equations (3) and (4), yields

$$v_{CS}(k) - v_{CS}(k+1) = A_{CS} \cdot R_{ON} \cdot I_R . \tag{5}$$

If the test current $I_R$ is known, the on-resistance $R_{ON}$ can be calculated according to equation (5). The test current $I_R$ could be supplied by any current source. In the example of figure 2a it is supplied by the first supply terminal VIN via a series circuit of a shunt-resistor $R_S$ and a current-limiting further resistor $R_{lim}$. As mentioned above, the test current can be measured by observing the voltage drop over the shunt-resistor $R_S$ and the test current can be calculated from the measured voltage according to equation (2). Substituting equation (2) into equation (5) yields the following expression for the on-resistance $R_{ON}$:

$$R_{ON} = \frac{v_{CS}(k) - v_{CS}(k+1)}{v_R(k+1)\dfrac{A_{CS}}{A_R R_S}} = \frac{v_{CS}(k) - v_{CS}(k+1)}{g \cdot v_R(k+1)} , \tag{6}$$

wherein the variable g denotes a scaling factor which is equal to $A_{CS}/(A_R R_S)$ and a value $v_R$ (k+1) of the second measurement signal $v_R$ (further denoted as "third measurement value) represents the test current $I_R$.

Of course the calculation of the on-resistance $R_{ON}$ can be performed digitally by any arithmetic/logic-unit (ALU), for example, a microcontroller. For a digital signal processing the first measurement value $V_{CS}$ (k), the second measurement value $v_{CS}$ (k+1), and the third measurement value $v_R$ (k+1) are replaced by their digital representations (first digital value $q_{CS}$ (k), second digital value $q_{CS}$ (k+1), and third digital value $q_R$ (k+1)). The on-resistance are on then calculates (cf. equation 6) as the quotient of the difference $q_{CS}$ (k) - $q_{CS}$ (k+1) and a digital representation ($q_R \cdot A_{CS}/(A_R R_S)$) of the test current $I_R$.

The above described determination of the on-resistance $R_{ON}$ for calibrating the current measurement of the load current of the transistor under test requires the value of the shunt-resistor $R_S$ to be known. Any error of the value of the shunt-resistor $R_S$ will propagate and will result in a respective systematic error in the calculated value for the on-resistance $R_{ON}$ and therefore in a systematic error in the load current measurement, too. It is therefore useful to measure the value of the shunt-resistor $R_S$ once, for example, during the chip testing after the production process. The measured value for the shunt-resistor $R_S$ can then be saved into a non-volatile memory, for example into an EEPROM of a microcontroller which may also be used to perform the above-mentioned calculations.

Figure 2b shows one simple method for measuring the shunt-resistor $R_S$ by using a precalibrated current source being connected to the control circuit 10 in place of the load-path of the low-side transistor LT. When switch Sw is closed, a test current flows from a first supply terminal (VCC) via the shunt resistor $R_s$ and the current limiting resistor $R_{lim}$ into the current source which replaces the load-path of the low-side transistor LT of figure 2a. The test current is forced to assume a value $I_{test}$ by the current source, since the current source is precalibrated to sink an exactly defined current $I_{test}$. The resistance value of the shunt-resistor $R_S$ can be calculated from the voltage drop across the shunt-resistor $R_S$.

Measuring the shunt-resistance $R_s$ comprising the steps of:

(a) Forcing the test current $I_R$ to assume a predefined current value $I_{test}$ by means of a current source, the test current $I_R$ thereby flowing through the shunt-resistor $R_S$. The control circuit 10 thereby must not be connected to the transistor LT or, if connected to a transistor, a control signal has to be applied to the control terminal of the respective transistor such, that the transistor is switched into an off-state.

(b) Measuring a voltage drop $R_s \cdot I_{test}$ across the shunt-resistor $R_S$ yielding a fourth measurement value $v_R(j)$. This fourth measurement value $V_R(j)$ is the output voltage of the second amplifier 12 and calculates:

$$v_R(j) = A_R \cdot R_S \cdot I_{test} , \tag{7}$$

wherein the symbol j represents a time-index at the time the measurement is performed. Of course the fourth measurement value $V_R(j)$ can be digitized by the analog-digital-converter 13 yielding a fourth digital value $q_R(j)$.

(c) Determining a resistance value of the shunt-resistor from the fourth measurement value $V_R$ (j) and the predefined current value $I_{test}$. This calculation can be also performed digitally.

The calculated resistance value for the shunt-resistor $R_S$ can then be saved into a non-volatile memory as explained above for the use in further calculations which are performed in order to obtain measurement values for the on-resistance $R_{ON}$ as explained with reference to figure 2a.

## Claims

1. A method for measuring an on-resistance ($R_{ON}$) of a load-path of a transistor (LT), the transistor (LT) having a control terminal (LG) and being connected between a first and a second supply terminal (VIN, PGND), the method comprising the following steps:

- applying a control signal to the control terminal (LG) of the transistor (LT) for switching the transistor (LT) into an on-state, such that the transistor (LT) carries a load current ($I_L$),
- measuring a voltage drop across the load-path of the transistor (LT) yielding a first measurement value ($v_{CS}(k)$),
- feeding a test current ($I_R$) into the load-path of the transistor (LT), such that the test current ($I_R$) and the load current ($I_L$) superpose,
- measuring a voltage drop across the load-path of the transistor (LT) yielding a second measurement value ($v_{cs}(k+1)$),
- determining the on-resistance ($R_{ON}$) of the load-path of the transistor (LT) from the difference of the first and the second measurement value ($v_{cs}(k) - v_{cs}(k+1)$).

2. The method of claim 1, further comprising the steps of

- amplifying by a first factor ($A_{cs}$) the voltage drop ($R_{ON} \cdot I_L$) across the load-path of the transistor (LT) yielding the first measurement value ($v_{cs}(k)$),
- digitising the first measurement value ($v_{cs}(k)$) yielding a first digital value ($q_{CS}(k)$),
- amplifying by the first factor ($A_{CS}$) the voltage drop ($R_{ON} \cdot (I_L - I_R)$) across the load-path of the transistor (LT) yielding the second measurement value ($v_{CS}(k)$),
- digitising the second measurement value ($v_{CS}(k+1)$) yielding a second digital value ($q_{CS}(k+1)$).

3. The method of claim 2, where the on-resistance is determined by

- calculating the difference ($q_{CS}(k) - q_{CS}(k+1)$) between the first digital value and the second digital value and by
- dividing the difference ($q_{CS}(k) - q_{CS}(k+1)$) by a digital representation ($q_R \cdot A_{CS}/(A_R R_S)$) of the test current ($I_R$), the quotient of the difference ($q_{CS}(k) - q_{CS}(k+1)$) and the digital representation ($q_R \cdot A_{CS}/(A_R R_S)$) of the test current ($I_R$) being a digital representation of the on-resistance ($R_{ON}$).

4. The method of claim 3, where the digital representation ($q_R \cdot A_{CS}/(A_R R_S)$) of the test current ($I_R$) is proportional to the test current.

5. The method of one of the previous claims, where the test current ($I_R$) is determined by a resistance ($R_S + R_{lim}$) being disposed between the load-path of the transistor (LT) and one of the supply terminals (VIN, GND), the resistance being a series circuit of a shunt resistor ($R_S$) and a further resistor ($R_{lim}$).

6. The method of claim 5 comprising the step of measuring the voltage drop ($R_S \cdot I_R$) across the shunt resistor ($R_S$) yielding a third measurement value ($v_R$).

7. The method of claim 6 comprising the steps of

- amplifying by a second factor ($A_R$) the voltage drop ($R_S \cdot I_R$) across the shunt resistor ($R_S$) yielding the third measurement value ($v_R$),
- digitising the third measurement value ($v_R$) yielding a third digital value ($q_R(k+1)$).

8. The method of one of claims 5 to 7 comprising the steps of

- forcing the test current ($I_R$) to assume a predefined current value ($I_{test}$) by means of a current source, the test current ($I_R$) flowing through the shunt resistor ($R_S$),
- measuring the voltage drop ($R_S \cdot I_{test}$) across the shunt resistor ($R_S$) yielding a fourth measurement value ($v_R(j)$),
- determining a resistance value of the shunt resistor from the fourth measurement value ($v_R(j)$) and the predefined current value ($I_{test}$).

9. Circuit arrangement for measuring an on-resistance ($R_{ON}$) of a load-path of a first transistor (LT), the first transistor (LT) being connected between a first and a second supply terminal (VIN, PGND) and carrying a load current ($I_L$), the circuit arrangement comprising

- a measurement device connected with the first transistor (LT) for measuring the voltage drop across the load-path of the first transistor (LT) and for providing a measurement signal ($v_{CS}$) being a representation of the voltage drop,
- a switchable current source (Sw, $R_S + R_{lim}$) for providing a test current ($I_R$) to the load-path of the first transistor (LT), such that the test current ($I_R$) and the load current ($I_L$) can superpose, the current source being capable of being switched on and off by a switch (Sw) which is responsive to a control signal,

- an evaluation circuit adapted for providing a control signal for the switch (Sw), for storing the measurement signal ($v_{CS}$), and for calculating the on-resistance ($R_{ON}$) of the load-path of the first transistor (LT) from the test current ($I_R$), an actual measurement signal ($v_{CS}(k+1)$), and a stored measurement signal ($v_{CS}(k)$), where at least one of the measurement signals ($v_{CS}(k)$, $v_{CS}(k+1)$) has been measured with the current source switched on.

**10.** Circuit arrangement of claim 9, where the evaluation circuit comprises at least one amplifier (11, 12), at least one amplifier being configured to amplify the voltage drop over the load-path of the first transistor (LT).

**11.** Circuit arrangement of claim 10, where the evaluation circuit comprises at least one analog-to-digital-converter (13, 14).

**12.** Circuit arrangement of claim 11, where the analog-to-digital-converter (13, 14) is connected to an output of the amplifier (12, 11) for providing a digital value representing the voltage drop over the load-path of the first transistor (LT).

**13.** Circuit arrangement of claim 12, where the switchable current source comprise a shunt resistor ($R_S$) for providing a voltage signal representing the test current ($I_R$).

**14.** Circuit arrangement of claim 13, where the evaluation circuit comprises at least one amplifier (11, 12), at least one amplifier being configured to amplify the voltage signal provided by the shunt resistor ($R_S$).

**15.** Circuit arrangement of claim 14, where the evaluation circuit comprises at least one analog-to-digital-converter (13, 14) being connected to an output of the amplifier (12, 11) for providing a digital value representing the test current ($I_R$).

**16.** Circuit arrangement of claim 15, where the evaluation circuit comprises an arithmetic unit for calculating the on-resistance ($R_{ON}$) of the load-path of the first transistor (LT); the arithmetic unit being configured to calculate the difference of the digital value representing the voltage drop over the load path with the current source switched on and of a digital value representing the voltage drop over the load path with the current source switched off, further configured to calculate the quotient of the difference and a digital value proportional to the test current.

# Fig. 1

# Fig. 2a

# Fig. 2b

**European Patent Office**

**EUROPEAN SEARCH REPORT**

Application Number

EP 07 01 3817

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 06 066857 A (YOKOGAWA ELECTRIC CORP) 11 March 1994 (1994-03-11) * the whole document * ----- | 1-16 | INV. G01R31/26 ADD. H03K17/687 |
| A | US 2006/022346 A1 (FELDTKELLER MARTIN [DE]) 2 February 2006 (2006-02-02) * paragraphs [0035] - [0048]; figure 2 * ----- | 1-16 | |

TECHNICAL FIELDS SEARCHED (IPC)

G01R
H03K

The present search report has been drawn up for all claims

| Place of search | Date of completion of the search | Examiner |
|---|---|---|
| The Hague | 1 February 2008 | Meulemans, Bart |

**ANNEX TO THE EUROPEAN SEARCH REPORT**
**ON EUROPEAN PATENT APPLICATION NO.**

EP 07 01 3817

This annex lists the patent family members relating to the patent documents cited in the above-mentioned European search report.
The members are as contained in the European Patent Office EDP file on
The European Patent Office is in no way liable for these particulars which are merely given for the purpose of information.

01-02-2008

| Patent document cited in search report | | Publication date | Patent family member(s) | | Publication date |
|---|---|---|---|---|---|
| JP 6066857 | A | 11-03-1994 | JP | 3196859 B2 | 06-08-2001 |
| US 2006022346 | A1 | 02-02-2006 | DE 102004035604 B3 | | 11-08-2005 |

For more details about this annex : see Official Journal of the European Patent Office, No. 12/82